## Europäisches Patentamt

## European Patent Office

## Office européen des brevets

(19)

(11)  **EP 0 639 307 B1**

(12)  **EUROPÄISCHE PATENTSCHRIFT**

(45) Veröffentlichungstag und Bekanntmachung des Hinweises auf die Patenterteilung:
**03.12.1997  Patentblatt 1997/49**

(21) Anmeldenummer: **94906818.3**

(22) Anmeldetag: **03.03.1994**

(51) Int Cl.6: **H03F 3/217**

(86) Internationale Anmeldenummer:
**PCT/CH94/00045**

(87) Internationale Veröffentlichungsnummer:
**WO 94/21035 (15.09.1994 Gazette 1994/21)**

(54) **MODULATIONSVERSTÄRKER FÜR RUNDFUNKSENDER**

**MODULATION AMPLIFIER FOR RADIO TRANSMITTERS**

**AMPLIFICATEUR DE MODULATION POUR EMETTEURS RADIO**

(84) Benannte Vertragsstaaten:
**CH DE FR GB LI**

(30) Priorität: **04.03.1993  DE 4306690**

(43) Veröffentlichungstag der Anmeldung:
**22.02.1995  Patentblatt 1995/08**

(73) Patentinhaber: **THOMCAST AG
5300 Turgi (CH)**

(72) Erfinder:
• **PURI, Narindra, Nath
Monmouth Junction, NJ 08852 (US)**
• **GEHRI, Patrick
CH-5223 Riniken (CH)**

• **KYRIAN, Bohumil
CH-5224 Unterbözberg (CH)**
• **NIKLAUS, Peter
CH-5430 Wettingen (CH)**
• **TOMLJENOVIC, Juraj
CH-5306 Tegerfelden (CH)**
• **TOMLJENOVIC, Nenad
CH-5415 Nussbaumen (CH)**

(74) Vertreter: **Hug Interlizenz AG
Nordstrasse 31
8035 Zürich (CH)**

(56) Entgegenhaltungen:
**EP-A- 0 557 599          FR-A- 2 567 338
US-A- 5 132 637**

**Beschreibung**

**Technisches Gebiet**

Die Erfindung bezieht sich auf das Gebiet Rundfunksendertechnik. Sie geht aus von einem Modulationsverstärker gemäss dem Oberbegriff des ersten Anspruchs.

**Stand der Technik**

Ein solcher Modulationsverstärker ist schon aus der Europäischen Patentschrift EP-B1-0 083 727 bekannt.

Ein Modulationsverstärker dieser Art umfasst einen Signalwandler, welcher ein NF-Eingangssignal in ein Mehrzahl von Steuersignalen umwandelt, eine Mehrzahl von HF-Stufen, welche von den Steuersignalen angesteuert werden, sowie eine HF-Oszillator.

Die HF-Stufen sind unabhängig ein- und ausschaltbar und geben an ihren Ausgängen ein hochfrequentes Signal ab. Die Ausgangssignale diese HF-Stufen werden in einem Summierer addiert. Es werden nun immer so viele Stufen angesteuert bzw. eingeschaltet, dass sich die Amplitude des hochfrequenten Summensignal stufenförmig nach Massgabe des NF-Eingangssignals ändert. Auf diese Art moduliert das NF-Signal die Amplitude einer HF-Schwingung. Gleichzeitig erreicht man durch die Addition der Ausgangssignale der HF-Stufen, welche z.B. einige hundert Volt betragen können, eine erhebliche Leistungsverstärkung.

Weiter sind Mittel vorhanden, welche der Approximation der Differenz des stufenförmigen Summensignal und der zu verstärkenden NF-Amplitude dienen.

Diese Mittel umfassen in der o.g. Schrift 4 HF-Stufen mit binär gewichteten Amplituden von 1/2, 1/4, 1/8 und 1/16 der Amplitude der übrigen 31 Grobstufen.

Nachteilig ist bei dieser Anordnung, dass unterschiedliche Typen von Stufen eingesetzt werden müssen und die Stufen mit binär gewichteter Amplitude zeitlich sehr viel stärker beansprucht werden, als die übrigen, gleichartigen Grobstufen. Durch die ungleichmässige Beanspruchung der Stufen wird der Modulationsverstärker inhärent störungsanfällig. Bei defekten binär gewichteten Stufen können die anderen Stufen deren Aufgabe nicht übernehmen. Als Folge davon entsteht ein HF-Störspektrum, das die Nachbarkanäle störend beeinflusst und die NF-Qualität verschlechtert.

Aus verschiedenen älteren Publikationen (H. Chireix: "High Power Outphasing Modulation" in Proceedings of the Institute of Radio Engineers, Vol. 23, No. 11, Nov. 1935; G. Clark: "A Comparison of Current Broadcast Amplitude-Modulation Techniques", in IEE Transactions on Broadcasting, Vol. BC-21, No. 2, June 1975; D.R. Mousson: "Ampliphase for Economical Super-Power AM Transmitters", in Broadcast Transmitter Engineering; F.J. Casadevall: "The LINC Transmitter", in RF Design, Feb. 1990) ist eine spezielle Art der Amplituden-Modulation, die sog. Ampliphase-Modulation, bekannt.

In der Europäischen Patentanmeldung EP-A2-0 273 827 wird diese Modulationsart für einen Sender angewendet. Dieser Sender besteht aus zwei Teilsendern, welche mit verschiedenen Phasen angesteuert werden, einer Einheit, welche die Phasen der Sender in Abhängigkeit eines Eingangssignals steuert, sowie einem Summationsnetzwerk, welches die Ausgangssignale der beiden Teilsender addiert, derart, dass an der nachgeschalteten Antenne ein amplituden- und phasenmoduliertes Signal abgegeben wird, dessen Amplitude nach Massgabe des Eingangssignals ändert. Durch die Aufteilung des Senders auf zwei Teilsender wird die totale Senderleistung auf die beiden Teilsender aufgeteilt, so dass jeder Teilsender nur einen Teil der totalen Leistung aufweisen muss.

**Darstellung der Erfindung**

Aufgabe der vorliegenden Erfindung ist es, einen Modulationsverstärker anzugeben, dessen Mittel zur Feinapproximation keine inhärente Fehlerquelle darstellen.

Diese Aufgabe wird bei einem Modulationsverstärker der eingangs genannten Art durch die Merkmale des ersten Anspruchs gelöst.

Kern der Erfindung ist es also, dass die Mittel zur Feinapproximation und zur Grobapproximation gleichartige Stufen umfassen, wobei die Feinstufen mit unterschiedlichen Phasen angesteuert werden. Die Grob- und Feinstufen unterscheiden sich also nur durch die Phasen der Ansteuer- und Ausgangssignale. Ihr innerer Aufbau ist jedoch gleich. Dasselbe gilt für die Ausgangsamplituden und -frequenz.

In einem ersten Ausführungsbeispiel ist die Anzahl Stufen, welche mit der gleichen Phase angesteuert werden grösser als die Anzahl Stufen, welche mit verschiedenen Phasen angesteuert werden. Dadurch erhält man einen Modulationsverstärker, bei welchem das summierte Ausgangssignal der gleichphasigen Stufen einen im wesentlichen stufenförmigen Amplitudenverlauf aufweist, während die Feinapproximation durch verschiedenphasige Stufen ausgeführt wird.

In einem zweiten Ausführungsbeispiel ist die Anzahl Stufen, welche mit der gleichen Phase angesteuert werden kleiner als die Anzahl Stufen, welche mit verschiedenen Phasen angesteuert werden. Im Extremfall werden sogar alle Stufen mit unterschiedlichen Phasen angesteuert. Damit erhält man einen Modulationsverstärker, dessen Ausgangssignalamplitude nach Massgabe eines NF-Eingangssignals variiert und durch die Summe einer Vielzahl von gleichfrequenten Schwingungen mit verschiedener Phase approximiert wird.

Weitere Ausführungsbeispiele ergeben sich aus den Unteransprüchen.

Der Vorteil des erfindungsgemässen Aufbaus besteht darin, dass alle verwendeten Stufen den gleichen Aufbau und die gleichen Ausgangsamplituden aufweisen und nur durch unterschiedliche Steuersignale angesteuert werden. Dadurch erhält man einen Modulationsverstärker, der sich insbesondere durch Einfachheit und Robustheit auszeichnet. Die Gleichartigkeit der Stufen erlaubt ausserdem eine grosse Flexibilität bezüglich des Aufbaus des Verstärkers, so dass mit den selben Mitteln sowohl Verstärker aufgebaut werden können, bei denen nur die Feinapproximation durch phasenverschobene Signale realisiert wird als auch solche bei denen die gesamte Approximation durch phasenverschobene Signale realisiert wird.

Durch den erfindungsgemässen Aufbau vermeidet man die Fehlerquelle, welche einem Modulationsverstärker durch die ungleichmässige Belastung aller Stufen anhaftet.

## Kurze Beschreibung der Zeichnungen

Nachfolgend wird die Erfindung anhand von Ausführungs-beispielen im Zusammenhang mit den Zeichnungen näher erläutert.

Es zeigen:

**Fig. 1**    Die Vektor-Darstellung der Addition zweier Signale mit unterschiedlicher Phase;

**Fig. 2**    Das Blockschaltbild eines erfindungsgemässen Modulationsverstärkers nach einem ersten Ausführungsbeispiel;

**Fig. 3**    Die Grobapproximation eines NF-Signals mittels mehrerer, gleichphasiger HF-Signale;

**Fig. 4**    Die Feinapproximation der Differenz des Amplitudenverlaufs des verstärkten NF-Signals und der Grobapproximation nach Fig. 3;

**Fig. 5**    Das Blockschaltbild einer erfindungsgemässen Modulationsverstärkers nach einem zweiten Ausführungsbeispiel;

**Fig. 6**    Das Blockschaltbild eines Rundfunksenders mit einem erfindungsgemässen Modulationsverstärker; sowie

**Fig. 7**    Den Ausgangskreis eines erfindungsgemässen Rundfunksenders nach einer ersten Variante

**Fig. 8**    Den Ausgangskreis eines erfindungsgemässen Rundfunksenders nach einer zweiten Variante.

Die in den Zeichnungen verwendeten Bezugszeichen und deren Bedeutung sind in der Bezeichnungsliste zusammengefasst aufgelistet. Grundsätzlich sind in den Figuren gleiche Teile mit gleichen Bezugszeichen versehen.

## Wege zur Ausführung der Erfindung

Ein Signal der Art $A\cos(2\pi f_0 t + \Phi(t))$ kann als mit der Kreisfrequenz $w_0 = 2\pi f_0$ und der Phase $\Phi(t)$ rotierender Vektor der Länge A dargestellt werden.

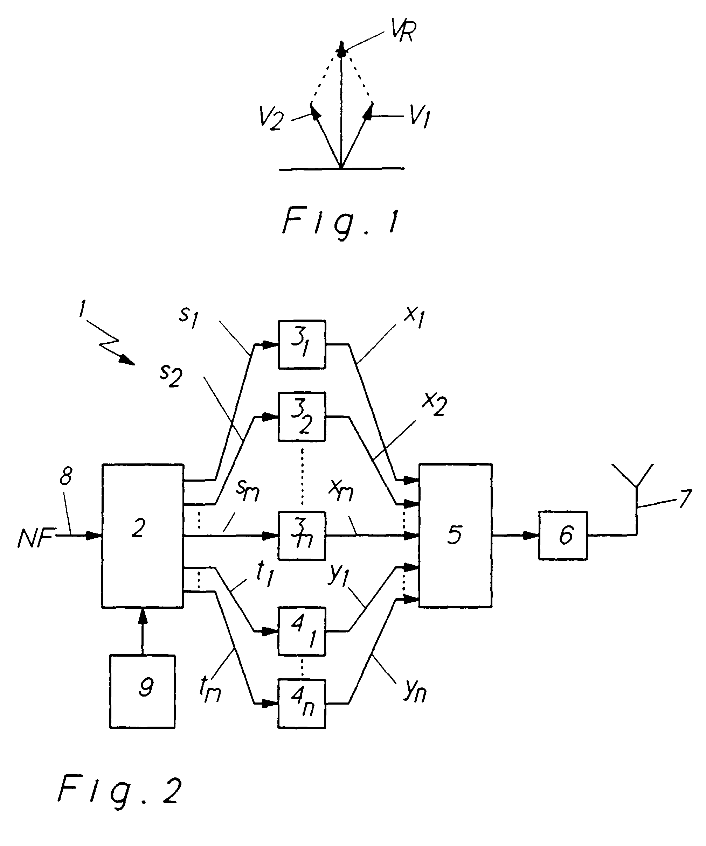

In **Figur 1** ist die Vektoraddition zweier Signale V1 und V2 mit gleicher Amplitude und Frequenz aber unterschiedlicher Phase dargestellt. V1 entspreche dem Signal s1, V2 dem Signal s2.

Mit

$$s1(t) = A\cos(w_0 t + \Phi 1)$$

und

$$s2(t) = A\cos(w_0 t + \Phi 2)$$

wird

$$s1(t) + s2(t) = A\cos(w_0t + \Phi1) + A\cos(w_0t + \Phi2)$$

$$= A(\cos w_0t\cos\Phi1 - \sin w_0t\sin\Phi1)$$

$$+ A(\cos w_0t\cos\Phi2 - \sin w_0t\sin\Phi2)$$

$$= A\cos w_0t(\cos\Phi1 + \cos\Phi2) -$$

$$A\sin w_0t(\sin\Phi1 + \sin\Phi2)$$

$$= 2A\cos w_0t[\cos\frac{\Phi1+\Phi2}{2} \; \cos\frac{\Phi1-\Phi2}{2}] -$$

$$2A\sin w_0t[\sin\frac{\Phi1+\Phi2}{2} \; \cos\frac{\Phi1-\Phi2}{2}]$$

$$= 2A\cos\frac{\Phi1-\Phi2}{2} \; \cos(w_0t + \frac{\Phi1+\Phi2}{2})$$

$$= \underline{\underline{B\cos(w_0t + \Phi)}}$$

mit

$$B = 2A\cos\frac{\Phi1-\Phi2}{2} \qquad \text{und } \Phi = \frac{\Phi1+\Phi2}{2}$$

Die Summe der beiden Signale stellt also ein Vektor $V_R$ dar, der mit der Kreisfrequenz $w_0$ und der Phase $\Phi$ rotiert und dessen Amplitude von den Phasen der beiden Summanden V1 bzw. V2 abhängt. Im Maximalfall ($\Phi1-\Phi2 = 0$) wird die Amplitude B doppelt so gross wie die ursprünglichen Amplituden, im Minimalfall ($\Phi1-\Phi2 = 180°$) wird B zu Null.

Durch Steuerung der Phasen $\Phi1$ und $\Phi2$ kann also die Amplitude des resultierenden Signals gezielt verändert werden. Dies wir bei der "Ampliphase" genannten Modulationsart benützt.

Hierbei werden zwei Schwingungen mit gleicher Frequenz f0 aber unterschiedlicher Phase addiert. Stellt man sich die Schwingungen als rotierende Vektoren vor, so wird sofort klar, dass durch die Steuerung der Phasenverschiebung der Komponentenvektoren die Amplitude des resultierenden Summenvektors verändert werden kann. Dies kann nun natürlich so gemacht werden, dass die Amplitude des resultierenden Vektors nach Massgabe eines Nutzsignals ändert. Somit erhält man eine Schwingung der Frequenz f0, deren Amplitude nach Massgabe des Nutzsignals ändert, mit anderen Worten eine amplitudenmodulierte Schwingung.

Unter der Voraussetzung, dass alle Teilsignale die gleiche Amplitude aufweisen sollen (gleichartige Stufen), d.h. die Enden der Vektoren auf einem Kreis liegen, wird sofort klar, dass eine Modulation im obigen Sinne auch mit einer Vielzahl von Signalen vorgenommen werden kann.

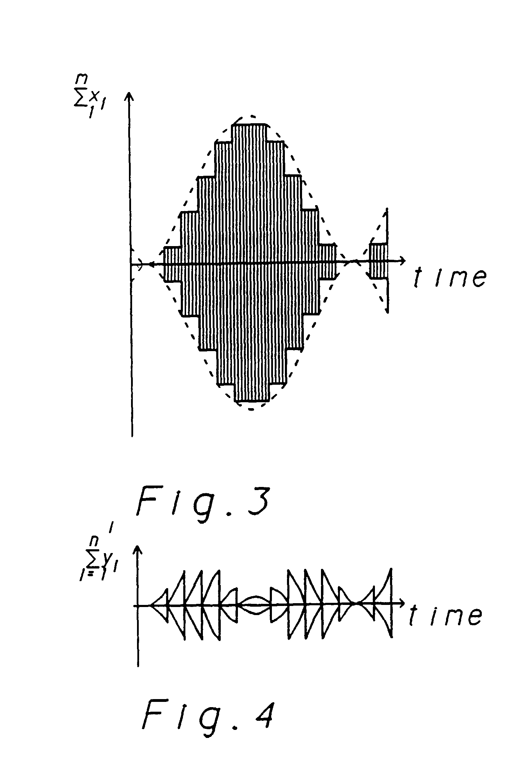

Aus der EP-B1-0 083 727 ist nun bekannt, dass der Amplitudenverlauf eines zu verstärkenden und zu modulierenden NF-Signals durch eine Addition von mehreren, gleichfrequenten und phasenmodulierten HF-Quellen approximiert werden kann. Durch eine solche Approximation entsteht eine hochfrequente Schwingung mit stufenförmiger Enveloppe, wie sie in **Figur 3** dargestellt ist.

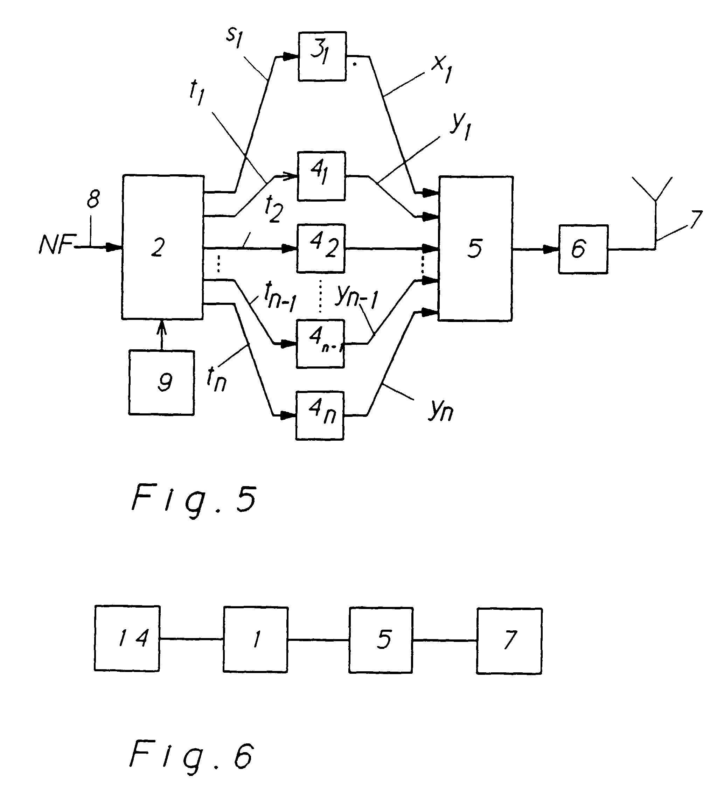

Die Idee der Erfindung besteht nun darin, die Differenz des verstärkten Amplitudenverlaufs, in Figur 3 gestrichelt dargestellt, und der stufenförmigen Enveloppe der hochfrequenten Summen-Schwingung, in **Figur 4** dargestellt, durch mehrere, phasenverschobene HF-Quellen zu approximieren.

In **Figur 2** ist das Blockschaltbild eines Modulationsverstärkers (1) dargestellt, welcher für die oben erläuterte Modulation verwendet werden kann. Nennen wir diese Modulationsart HF-Pulsstufenmodulation (HF-PSM), in Anlehnung an die Pulsstufenmodulation (PSM), welche aus mehreren älteren Patenten bekannt ist und bei welcher Gleichspannungsquellen addiert werden.

Ein solcher HF-PSM-Modulationsverstärker (1) besteht aus einem Signalwandler (2), einem HF-Oszillator (9), einem Summierer (5) und einer Vielzahl von unabhängig ansteuerbaren HF-Stufen ($3_{1-m}$ bzw. $4_{1-n}$). Am Ausgang des Summierers (5) kann ein Tiefpassfilter (6) angeschlossen werden. Das Tiefpassfilter (6) kann seinerseits mit einer Last (7), hier als Antenne dargestellt, in Verbindung stehen.

Die HF-Stufen ($3_{1-m}$) werden durch die Steuersignale ($s_{1-m}$) des Signalwandlers angesteuert und geben an ihren Ausgängen die hochfrequenten und vorzugsweise leistungsverstärkten Ausgangssignale ($x_{1-m}$) ab. Bei den HF-Stufen ($4_{1-n}$) heissen die entsprechenden Signale $t_{1-n}$ bzw. $y_{1-n}$. Im Summierer werden diese Ausgangssignale ($x_{1-m}$ bzw. $y_{1-n}$)

addiert.

Am NF-Eingang (8) des Signalwandlers (2) kann ein NF-Signal (NF) angeschlossen werden. Im Signalwandler (2) wird nun diejenige Anzahl HF-Stufen ($3_{1-m}$) angesteuert, dass die Schwingung am Ausgang des Summierers eine stufenförmige Enveloppe aufweist, welche eine Grob-Approximation des verstärkten NF-Signalverlaufs darstellt. Diese Anzahl ändert natürlich nach Massgabe des Verlaufs der Amplitude des Eingangssignals (NF). Die Steuersignale ($s_{1-m}$) weisen die Frequenz f0 und Phase $\Phi0$ des HF-Oszillators auf. Die Ausgangssignale ($x_{1-m}$) weisen jeweils dieselbe Frequenz f0 und Phase $\Phi0$ sowie untereinander dieselbe Amplitude auf.

Zusätzlich zu diesen gleichphasig angesteuerten Stufen ($3_{1-m}$) werden nun die HF-Stufen ($4_{1-n}$) mit verschiedenphasigen aber gleichfrequenten Steuersignalen ($t_{1-n}$) angesteuert. Die Anzahl der angesteuerten Stufen ($4_{1-n}$) und die Phasen $\Phi_{1-n}$ werden im Signalwandler so festgelegt, dass die Summe der Ausgangssignale ($y_{1-n}$) der Differenz des verstärkten NF-Amplitudenverlaufs und der stufenförmigen Enveloppe der Ausgangssignale ($x_{1-m}$) entspricht. Die Ausgangssignale ($y_{1-n}$) weisen also die gleiche Amplitude und Frequenz f0 aber verschiedene Phasen $\Phi_{1-n}$ auf.

Am Ausgang des Summierers entsteht folglich ein Signal welches zusammengesetzt ist aus der Grobapproximation durch die gleichphasigen Grob-Stufen ($3_{1-m}$) und der Feinapproximation durch die verschiedenphasigen Fein-Stufen ($4_{1-n}$). Durch die Kombination von gleichphasig angesteuerten Grobstufen und verschiedenphasig angesteuerten Feinstufen erreicht man ein Repräsentation des massgebenden NF-Signals, welche nahezu störungsfrei ist.

Wie oben dargelegt, sollte die Anzahl angesteuerter Feinstufen ($4_{1-n}$) grösser gleich 2 sein.

In einem ersten Ausführungsbeispiel ist die Anzahl Grobstufen ($3_{1-m}$) grösser als diejenige der Feinstufen ($4_{1-n}$) und n beträgt insbesondere 2.

Ein weiteres Ausführungsbeispiel zeichnet sich dadurch aus, dass die Anzahl gleichphasig angesteuerter HF-Stufen ($3_{1-m}$) kleiner als diejenige der mit verschiedenen Phasen $\Phi_{1-n}$ angesteuerten Stufen ($4_{1-n}$) ist. Bei einem solchem Modulationsverstärker übernehmen die verschiedenphasig angesteuerten Stufen ($4_{1-n}$) einen immer höheren Anteil der gesamten Senderleistung. Im Extremfall, in Figur 5 dargestellt, ist m=1. Das heisst, es wird nur noch eine einzige Stufe mit Steuersignalen angesteuert, welche die gleiche Phase $\Phi0$ wie der HF-Oszillator (9) aufweisen.

Mit einer solchen Anordnung erhält man einen Modulationsverstärker, dessen Ausgangsamplitudenverlauf durch eine endliche Summe von untereinander verschiedenphasigen HF-Schwingungen erzeugt wird. Durch die Festlegung der Phasen und der Anzahl angesteuerter Stufen kann die Ausgangsamplitude beliebig nach Massgabe des NF-Eingangssignals verändert werden. Die Ausgangsamplitude kann von Null nahezu kontinuierlich bis zu einem Maximalwert eingestellt werden. Der Maximalwert wird durch Addition der Ausgangssignale aller Stufen und gleichphasige Ansteuerung erreicht. Der Verlauf der Ausgangsamplitude wir dadurch sehr glatt und weist kaum mehr Stufen auf. Dadurch können Störungen weitgehend vermieden werden. Ein derartiger Modulationsverstärker ist somit bezüglich des Klirrfaktors dem Stand der Technik überlegen.

Beiden Ausführungsbeispielen ist gemeinsam, dass sie in einem Rundfunksender, welcher eine NF-Signalquelle (14), einen Tiefpass (6) zur Glättung des Sendesignals und eine Last (7), meistens in Form einer Antenne, umfasst, eingesetzt werden können. Zu diesem Zweck ist der erfindungsgemässe Modulationsverstärker (1) zwischen der NF-Signalquelle (14) und dem Tiefpass (6) geschaltet. Dies ist in **Figur 6** dargestellt.

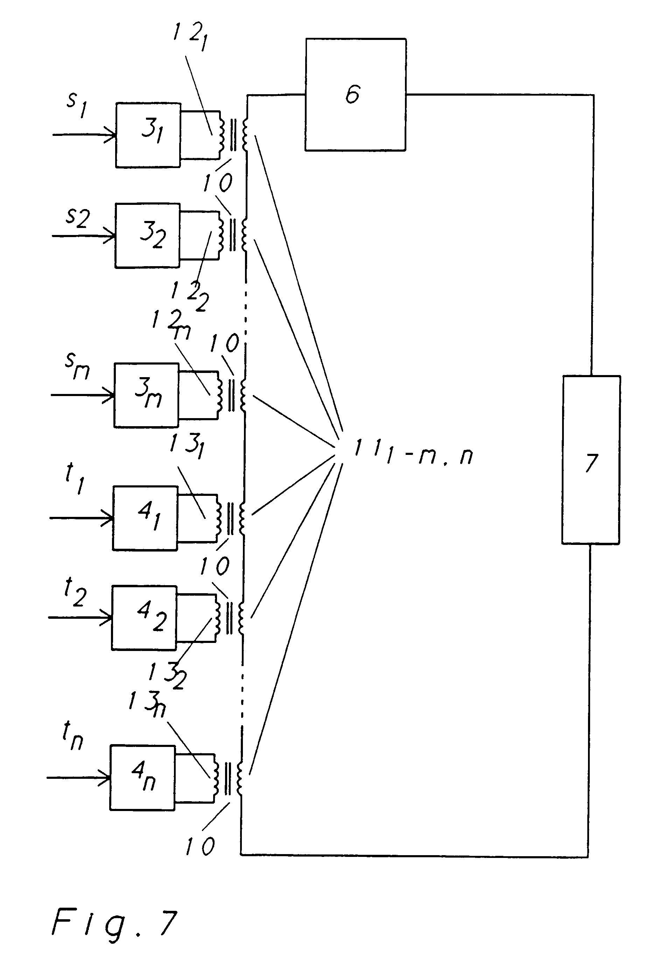

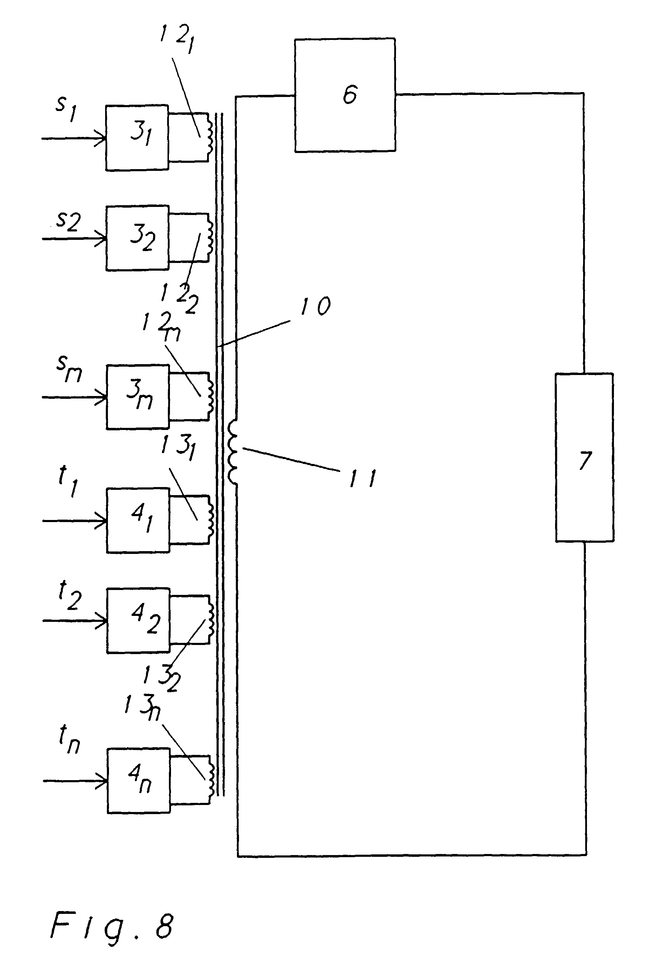

Der Summierer (5) des erfindungsgemässen Modulationsverstärkers (1) ist vorzugsweise als Transformator (10) ausgebildet. Dieser Transformator (10) weist pro HF-Stufe je eine Primärwicklung ($12_{1-m}$, $13_{1-n}$) und eine Sekundärwicklung (11) (siehe **Figur 8**) auf. Eine zweite Variante weist n+m Transformatoren mit Primärwicklungen ($12_{1-m}$, $13_{1-n}$) und in Serie geschaltete Sekundärwicklungen ($11_{1-m,n}$) auf (siehe **Figur 7**).

Die Steuersignale ($s_{1-m}$ bzw. $t_{1-n}$) können auch mehrere physikalische Leitungen umfassen. Beispielsweise sind drei Leitungen denkbar: eine, welcher der Phase $\Phi0$ des Oszillators, und zwei, welche der positiven bzw. Phasenverschiebung der entsprechenden Stufe zugeordnet sind. Der Signalwandler (2) entscheidet dann jeweils, welche Leitung mit welchen Signalen beaufschlagt werden. Dies führt dazu, dass die Stufen ($3_{1-m}$ bzw. $4_{1-n}$) auch bezüglich der physikalischen Leitungen der Steuersignale ($s_{1-m}$ bzw. $t_{1-n}$) beliebig ausgetauscht werden können.

Selbstverständlich können die Gruppen der Stufen beliebig aufgeteilt werden. Da alle Stufe im Prinzip gleich aufgebaut sind und nur unterschiedlich angesteuert werden, kann beim Ausfall einer Stufe jede andere deren Funktion übernehmen. Weiter ist denkbar, dass zu verschiedenen Zeiten verschiedene Stufen der einen bzw. der anderen Gruppe angehören. Ein gleichförmige Belastung der Stufen wird zudem dadurch erreicht, dass zu verschiedenen Zeitpunkten für gleiche (auch konstante) Ausgangsamplitudenwerte unterschiedliche Stufen angesteuert werden.

Die Zuordnung der Stufen kann also im Signalwandler (2) beliebig festgelegt werden. Durch diesen Umstand, durch die völlige Gleichartigkeit im Aufbau der Stufen und durch die beliebige Ansteuerung durch den Signalwandler (2) erhält man einen Modulationsverstärker, welcher sich durch eine ausserordentliche Flexibilität und Robustheit des Aufbaus auszeichnet.

**Bezeichnungsliste**

1          Modulationsverstärker

| | | |
|---|---|---|
| 2 | | Signalwandler |
| $3_{1-m}$ | | HF-Stufen 1-m (Grob-Stufen) |
| $4_{1-n}$ | | HF-Stufen 1-n (Fein-Stufen) |
| 5 | | Summierer |
| 6 | | Tiefpass |
| 7 | | Last |
| 8 | | NF-Signal-Eingang |
| 9 | | HF-Oszillator |
| 10 | | Transformator |
| $11_{1-m,n}$ | | Sekundärwicklungen |
| $12_{1-m}$ | | Primärwicklungen der HF-Stufen ($3_{1-m}$) |
| $13_{1-n}$ | | Primärwicklungen der HF-Stufen ($4_{1-n}$) |
| 14 | | NF-Signalquelle |

| | |
|---|---|
| V1 | Vektor 1 |
| V2 | Vektor 2 |
| $V_R$ | resultierender Vektor |
| $s_{1-m}$ | Steuersignale 1-m |
| $t_{1-n}$ | Steuersignale 1-n |
| $x_{1-m}$ | Ausgänge 1-m |
| $y_{1-n}$ | Ausgänge 1-n |
| $\Phi_{1-m}$ | Phasen 1-m |
| $\Phi_{1-n}$ | Phasen 1-n |
| $\Phi_0$ | Phase 0 |
| NF | NF-Signal |

**Patentansprüche**

1. Modulationsverstärker (1) umfassend

a) einen Signalwandler (2), welcher ein an einem NF-Eingang (8) anliegendes NF-Signal (NF) in eine erste Gruppe von m (m≥1) von Steuersignalen ($s_{1-m}$) umwandelt;

b) einen HF-Oszillator (9), welcher ein hochfrequentes Signal der Frequenz $f_0$ und der Phase $\Phi_0$ abgibt;

c) m unabhängig ansteuerbare HF-Stufen ($3_{1-m}$), welche durch die Steuersignale ($s_{1-m}$) angesteuert werden und an ihren Ausgängen ($x_{1-m}$) im eingeschalteten Zustand HF-Signale der Frequenz $f_0$, Phase $\Phi_0$ und untereinander gleicher Amplitude abgeben;

d) einen Summierer (5), welcher die Ausgänge ($x_{1-m}$) der HF-Stufen ($3_{1-m}$) summiert und das Summensignal an einen Tiefpass (6) weitergibt, an dessen Ausgang eine Last (7) angeschlossen werden kann, wobei

e) der Signalwandler (2) soviele HF-Stufen ($3_{1-m}$) angesteuert, dass das Ausgangssignal des Summierers (5) eine leistungsverstärkte, hochfrequente Schwingung darstellt deren Amplitude stufenförmig nach Massgabe des NF-Signals (NF) ändert; sowie

f) Mittel zur Approximation der Differenz der verstärkten Amplitude des NF-Signals (NF) und des stufenförmigen Ausgangssignals des Summierers (5);

dadurch gekennzeichnet, dass

g) die Mittel zur Approximation der Differenz der verstärkten Amplitude des NF-Signals (NF) und des stufenförmigen Ausgangssignals des Summierers (5) eine zweite Gruppe von n, n≥2, unabhängig ansteuerbaren HF-Stufen ($4_{1-n}$) umfassen, welche

h) durch eine zweite Gruppe von n hochfrequenten, vom Signalwandler (2) stammenden Steuersignalen ($t_{1-n}$) gleicher Frequenz $f_0$ aber unterschiedlicher Phase $\Phi_{1-n}$ angesteuert werden, und

i) welche HF-Stufen ($4_{1-n}$) an ihren Ausgängen ($y_{1-n}$) HF-Signale der Frequenz $f_0$, gleicher Amplitude aber verschiedener Phase $\Phi_{1-n}$ abgeben, wobei

j) der Signalwandler (2) die Anzahl angesteuerter HF-Stufen ($4_{1-n}$) und deren Phasen ($\Phi_{1-n}$) so festlegt, dass die Summe Ausgangssignale ($y_{1-n}$) der zweiten Gruppe von HF-Stufen ($4_{1-n}$) eine hochfrequente Schwingung darstellt, deren Amplitude der Differenz des verstärkten NF-Signals und der stufenförmigen Repräsentation des NF-Signals durch die HF-Stufen ($3_{1-m}$) entspricht.

**2.** Modulationsverstärker nach Anspruch 1, dadurch gekennzeichnet, dass die Anzahl der HF-Stufen ($3_{1-m}$) grösser oder gleich der Anzahl der HF-Stufen ($4_{1-n}$), also $m \geq n$ ist.

**3.** Modulationsverstärker nach Anspruch 2, dadurch gekennzeichnet, dass die Anzahl der HF-Stufen ($3_{1-m}$) grösser als die Anzahl der HF-Stufen ($4_{1-n}$), also $m \geq n$ ist, und insbesondere $n = 2$ ist.

**4.** Modulationsverstärker nach Anspruch 1, dadurch gekennzeichnet, dass die Anzahl der HF-Stufen ($4_{1-n}$) grösser oder gleich der Anzahl der HF-Stufen ($3_{1-m}$), also $n \geq m$ ist.

**5.** Modulationsverstärker nach Anspruch 4, dadurch gekennzeichnet, dass Anzahl der HF-Stufen ($4_{1-n}$) grösser als die Anzahl der HF-Stufen ($3_{1-m}$), also $n \geq m$ ist und insbesondere $m = 1$ ist.

**6.** Modulationsverstärker nach einem der vorangehenden Ansprüche, dadurch gekennzeichnet, dass

a) der Ausgang des HF-Oszillatdrs (9) mit dem Signalwandler (2) verbunden ist; und
b) die Steuersignale ($s_{1-m}$) hochfrequent sind und dieselbe Phase $\Phi_0$ und Frequenz $f_0$ wie der HF-Oszillator aufweisen.

**7.** Modulationsverstärker nach einem der vorangehenden Ansprüche, dadurch gekennzeichnet, dass der Summierer (5) mindestens einen Transformator (10) umfasst.

**8.** Modulationsverstärker nach Anspruch 7, dadurch gekennzeichnet, dass der Transformator (10) mehrere Primär-wicklungen ($12_{1-m}$ bzw. $13_{1-n}$), welche je einer der HF-Stufen ($3_{1-m}$ bzw. $4_{1-n}$) zugeordnet sind, und eine einzige Sekundärwicklung (11), welche mit dem Tiefpass (6) und der Last (7) verbunden ist, umfasst.

**9.** Modulationsverstärker nach Anspruch 8, dadurch gekennzeichnet, dass der Summierer (5) $n+m$ Transformatoren (10) mit Primärwicklungen ($12_{1-m}$ bzw. $13_{1-n}$), welche je einer der HF-Stufen ($3_{1-m}$ bzw. $4_{1-n}$) zugeordnet sind, und mit Sekundärwicklungen ($11_{1-m,n}$), welche als Serieschaltung mit dem Tiefpass (6) und der Last (7) verbunden sind, umfasst.

**10.** Rundfunksender mit einer NF-Quelle (14), einem Modulationsverstärker sowie einem Tiefpass (6), welcher zwischen dem Modulationsverstärker und einer Last (7) angeordnet ist, dadurch gekennzeichnet, dass der Modulationsverstärker einen Modulationsverstärker (1) nach Anspruch 3 umfasst.

**11.** Rundfunksender mit einer NF-Quelle (14), einem Modulationsverstärker sowie einem Tiefpass (6), welcher zwischen dem Modulationsverstärker und einer Last (7) angeordnet ist, dadurch gekennzeichnet, dass der Modulationsverstärker einen Modulationsverstärker (1) nach Anspruch 5 umfasst.

## Claims

**1.** Modulation amplifier (1) comprising

a) a signal converter (2), which converts a LF signal (NF) applied to a LF input (8) into a first group of m ($m \geq 1$) of control signals ($s_{1-m}$),

b) a RF oscillator (9), which delivers a high frequency signal of frequency $f_0$ and phase $\phi_0$,

c) m independently controllable RF stages RF stages ($3_{1-m}$), which are controlled by the control signals ($s_{1-m}$) and deliver at their outputs ($x_{1-m}$) in the switched on state RF signals of frequency $f_0$, phase $\phi_0$ and of the same amplitude,

d) a summator (5), which summates the outputs ($x_{1-m}$) of the RF stages ($3_{1-m}$) and passes the composite signal to a low-pass filter (6), to whose output can be connected a load (7), in which

e) the signal converter (2) controls so many RF stages ($3_{1-m}$), that the output signal of the summator (5) represents a power-amplified, high frequency oscillation, whose amplitude changes in step-like manner in proportion to the LF signal (NF) and

f) means for approximating the difference of the amplified amplitude of the LF signal (NF) and the step-like output signal of the summator (5), characterized in that

g) the means for approximating the difference of the amplified amplitude of the LF signal (NF) and the step-like output signal of the summator (5) comprise a second group of n ($n \geq 2$) independently controllable RF stages ($4_{1-n}$), which

h) are controlled by a second group of n high frequency control signals ($t_{1-n}$) from the signal converter (2) and having the same frequency $f_0$, but a different phase $\phi_{1-n}$ and

i) which RF stages ($4_{1-n}$) deliver at their outputs ($y_{1-n}$) RF signals of frequency $f_0$, the same amplitude, but different phase $\phi_{1-n}$, in which

j) the signal converter (2) so fixes the number of controlled RF stages ($4_{1-n}$) and their phases ($\phi_{1-n}$), that the sum of the output signals ($y_{1-n}$) of the second group of RF stages ($4_{1-n}$) represents a high frequency oscillation, whose amplitude corresponds to the difference of the amplified LF signal and the step-like representation of the LF signal by the RF stages ($3_{1-m}$).

2. Modulation amplifier according to claim 1, characterized in that the number of RF stages ($3_{1-m}$) is equal to or larger than the number of RF stages ($4_{1-n}$), i.e. $m \geq n$.

3. Modulation amplifier according to claim 2, characterized in that the number of RF stages ($3_{1-m}$) is higher than the number of RF stages ($4_{1-n}$), i.e. $m \geq n$ and in particualr $n = 2$.

4. Modulation amplifier according to claim 1, characterized in that the number of RF stages ($4_{1-n}$) is equal to or larger than the number of RF stages ($3_{1-m}$), i.e. $n \geq m$.

5. Modulation amplifier according to claim 4, characterized in that the number of RF stages ($4_{1-n}$) is higher than the number of RF stages ($3_{1-m}$), i.e. $n \geq m$ and in particular $m = 1$.

6. Modulation amplifier according to one of the preceding claims, charaterized in that

a) the output of the RF oscillator (9) is connected to the signal converter (2) and

b) the control signals ($s_{1-m}$) are high frequency and have the same phase $\phi_0$ and frequency $f_0$ as the HF oscillator.

7. Modulation amplifier according to one of the preceding claims, characterized in that the summator (5) incorporates at least one transformer (10).

8. Modulation amplifier according to claim 7, characterized in that the transformer (10) has several primary windings ($12_{1-m}$ or $13_{1-n}$), in each case associated with one of the RF stages ($3_{1-m}$ or $4_{1-n}$), and a single secondary winding (11), which is connected to the low-pass filter (6) and the load (7).

9. Modulation amplifier according to claim 8, characterized in that the summator (5) incorporates $n + m$ transformers (10) with primary windings ($12_{1-m}$ or $13_{1-n}$), in each case associated with one of the RF stages ($3_{1-m}$ or $4_{1-n}$), and with secondary windings ($11_{1-m,n}$), which are connected as a series connection to the low-pass filter (6) and the load (7).

10. Radio transmitter with a LF source (14), a modulation amplifier and a low-pass filter (6), which is positioned between the modulation amplifier and a load (7), characterized in that the modulation amplifier comprises a modulation amplifier (1) according to claim 3.

11. Radio transmitter with a LF source (14), a modulation amplifier and a low-pass filter (6) which is positioned between the modulation amplifier and a load (7), characterized in that the modulation amplifier comprises a modulation amplifier (1) according to claim 5.

**Revendications**

1. Amplificateur de modulation (1) comprenant

   a) un convertisseur (2), lequel transforme un signal B.F. (NF) se trouvant à une entrée B.F. (8) en un premier groupe de m (m $\geq$ 1) signaux pilotes ($s_{1-m}$),
   b) un oscillateur R.F. (9), lequel émet un signal radioélectrique de fréquence $f_0$ et de phase $\Phi_0$,
   c) m étages radiofréquence ($3_{1-m}$) excitables de façon autonome, que commandent les signaux pilotes ($s_{1-m}$) et qui, lorsqu'ils sont sous tension, émettent à leurs sorties ($x_{1-m}$) des signaux radioélectriques de fréquence $f_0$, de phase $\Phi_0$ et d'amplitude égale,
   d) un additionneur analogue (5), lequel additionne les sorties ($x_{1-m}$) des étages radiofréquence ($3_{1-m}$) et transmet le signal composite à un filtre passe-bas (6) à la sortie duquel il est possible de connecter une charge (7),
   e) le convertisseur (2) excitant un nombre d'étages radiofréquence ($3_{1-m}$) tel que le signal de sortie de l'additionneur analogue (5) représente une oscillation radioélectrique amplifiée en puissance dont l'amplitude change en échelon en fonction du signal B.F. (NF), ainsi que
   f) des moyens permettant de faire une approximation de la différence d'amplitude amplifiée du signal B.F. (NF) et du signal de sortie en échelon de l'additionneur analogue (5),

   caractérisé en ce que

   g) les moyens permettant de faire l'approximation de la différence d'amplitude amplifiée du signal B.F. (NF) et du signal de sortie en échelon de l'additionneur analogue (5) comprennent un second groupe de n (n $\geq$ 2) étages radiofréquence ($4_{1-n}$) excitables de façon autonome, que
   h) commande un second groupe de n signaux pilotes ($t_{1-n}$) radioélectriques, provenant du convertisseur (2) et étant de même fréquence $f_0$ mais de phase $\Phi_{1-n}$ différente, et
   i) qui émettent à leurs sorties ($y_{1-n}$) des signaux radioélectriques de fréquence $f_0$, d'amplitude égale mais de phase $\Phi_{1-n}$ différente,
   j) le convertisseur (2) déterminant le nombre d'étages radiofréquence ($4_{1-n}$) excités et leurs phases ($\Phi_{1-n}$) de manière à ce que la somme des signaux de sortie ($y_{1-n}$) du second groupe d'étages radiofréquence ($4_{1-n}$) représente une oscillation radioélectrique dont l'amplitude correspond à la différence du signal B.F. amplifié et à la représentation en échelon du signal B.F. par l'intermédiaire des étages radiofréquence ($3_{1-m}$).

2. Amplificateur de modulation selon la revendication 1 caractérisé en ce que le nombre d'étages radiofréquence ($3_{1-m}$) est supérieur ou égal à celui des étages radiofréquence ($4_{1-n}$), c'est à dire que m $\geq$ n.

3. Amplificateur de modulation selon la revendication 2 caractérisé en ce que le nombre d'étages radiofréquence ($3_{1-m}$) est supérieur à celui des étages radiofréquence ($4_{1-n}$), c'est à dire que m $\geq$ n et que notamment n = 2.

4. Amplificateur de modulation selon la revendication 1 caractérisé en ce que le nombre d'étages radiofréquence ($4_{1-n}$) est supérieur ou égal à celui des étages radiofréquence ($3_{1-m}$), c'est à dire que n $\geq$ m.

5. Amplificateur de modulation selon la revendication 4 caractérisé en ce que le nombre d'étages radiofréquence ($4_{1-n}$) est supérieur à celui des étages radiofréquence ($3_{1-m}$), c'est à dire que n $\geq$ m et que notamment m = 1.

6. Amplificateur de modulation selon l'une des revendications précédentes caractérisé en ce que

   a) la sortie de l'oscillateur R.F. (9) est reliée au convertisseur (2) et
   b) les signaux pilctes ($s_{1-m}$) sont radioélectriques et de mêmes phase $\Phi_0$ et fréquence $f_0$ que l'oscillateur R.F.

7. Amplificateur de modulation selon l'une des revendications précédentes caractérisé en ce que l'additionneur analogue (5) comprend au moins un transformateur (10).

8. Amplificateur de modulation selon la revendication 7 caractérisé en ce que le transformateur (10) comprend plusieurs enroulements primaires ($12_{1-m}$ ou $13_{1-n}$), chacun étant respectivement affecté à l'un des étages radiofréquence ($3_{1-m}$ ou $4_{1-n}$), et un seul enroulement secondaire (11), lequel est relié au filtre passe-bas (6) et à la charge (7).

9. Amplificateur de modulation selon la revendication 8 caractérisé en ce que l'additionneur (5) comprend n+m transformateurs (10) avec des enroulements primaires ($12_{1-m}$ ou $13_{1-n}$), chacun étant respectivement affecté à l'un des étages radiofréquence ($3_{1-m}$ ou $4_{1-n}$), et des enroulements secondaires ($11_{1-m,n}$), lesquels sont reliés dans un montage en série au filtre passe-bas (6) et à la charge (7).

10. Emetteur de radiodiffusion avec une source B.F. (14), un amplificateur de modulation ainsi qu'un filtre passe-bas (6) disposé entre l'amplificateur de modulation et une charge (7), caractérisé en ce que l'amplificateur de modulation comprend un amplificateur de modulation (1) selon la revendication 3.

11. Émetteur de radiodiffusion avec une source B.F. (14), un amplificateur de modulation ainsi qu'un filtre passe-bas (6) disposé entre amplificateur de modulation et une charge (7), caractérisé en ce que l'amplificateur de modulation comprend un amplificateur de modulation (1) selon la revendication 5.

Fig. 1

Fig. 2

Fig.3

Fig.4

Fig.5

Fig.6

Fig. 7

Fig. 8